# EUROPEAN PATENT APPLICATION

(11) **EP 4 770 405 A1**
(43) Date of publication of application: **01.07.2026**
(21) Application number: 25218453.6
(22) Date of filing: 25.11.2025
(51) Int. Cl.: H10W 20/00, H10D 30/00, H10D 62/10, H10W 20/40

(54) **DIELECTRIC TRENCH PLUGS INSULATING TRANSISTOR SOURCE/DRAIN MATERIAL FROM BACKSIDE METALLIZATION**

(30) Priority: 26.12.2024 US 202419002562
(71) Applicant: Intel Corporation, Santa Clara, CA 95054 (US)
(72) Inventor: ZHANG, Kan, Hillsboro, 97123 (US); ZHANG, Feng, Hillsboro, 97124 (US); XU, Guowei, Portland, 97229 (US); CHU, Tao, Portland, 97229 (US); LUO, Yanbin, Portland, 97229 (US); LIN, Chung-Hsun, Portland, 97229 (US); ZHANG, Yang, Rio Rancho, 87124 (US); HUNG, Ting-Hsiang, Santa Clara, 95051 (US); LIN, Chia-Ching, Portland, 97229 (US); YEUNG, Chun Wing, Portland, 97229 (US); LU, Yuanfang, Hillsboro, 97123 (US); GHANI, Tahir, Portland, 97229 (US); HU, Lin, San Jose, 95124 (US); HUR, Jae, Hillsboro, 97123 (US); MLECZKO, Michal, Portland, 97229 (US); WANG, Qiwen, Portland, 97229 (US)
(74) Representative: 2SPL Patentanwälte PartG mbB

(57) **Abstract**

Transistor structures with a dielectric trench plug below source and drain semiconductor material. Following frontside processing, a workpiece may be inverted and backside interconnect metallization fabricated. The dielectric trench plug can electrically insulate the backside interconnect metallization from source and drain semiconductor material. In some examples, a dielectric trench plug is formed during frontside processing, backfilling a trench in subfin semiconductor material prior to the deposition of source and drain semiconductor material. In other examples, a dielectric trench plug is formed during backside processing. When source or drain semiconductor material is exposed with a backside planarization polish, a recess may be etched in the exposed semiconductor material and the recess backfilled with the dielectric trench plug.

## Description

### BACKGROUND

For advanced integrated circuits (ICs), front-side interconnect metallization dimensions continue to scale to smaller dimensions, increasing overall electrical resistance. Introducing back-side interconnect metallization, for example to supply transistors power, counters the trend of increasing electrical resistance.

Source and drain semiconductor material deposited during transistor fabrication can induce electrical shorts to back-side interconnect metallization, which can be detrimental to device yield, particularly within dense transistor arrays, such as static random-access memory (SRAM) arrays.

Transistor architectures that reduce occurrences of source/drain-to-backside metal shorts are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods of fabricating IC devices including transistor structures with source and drain material electrically insulated from backside metallization by an intervening dielectric trench plug, in accordance with some embodiments;
FIG. 2A and 2B are cross-sectional views of transistor structures evolving as the methods illustrated in FIG. 1 are practiced, in accordance with some embodiments;
FIG. 3A, 3B, 3C, 3D and 3E are cross-sectional views of IC die structures further evolving to include front-side and back-side transistor interconnects as the methods illustrated in FIG. 1 are practiced, in accordance with embodiments;
FIG. 4A, 4B, 4C and 4D are cross-sectional views of transistor structures evolving as the methods illustrated in FIG. 1 are practiced, in accordance with some alternative embodiments;
FIG. 5A and 5B are cross-sectional views of IC die structures further evolving to include front-side and back-side transistor interconnects as the methods illustrated in FIG. 1 are practiced, in accordance with some alternative embodiments;
FIG. 6 illustrates a mobile computing platform and a data server machine employing an IC device including transistor structures with source and drain material electrically insulated from backside metallization by intervening dielectric trench plugs, in accordance with some embodiments; and
FIG. 7 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. In one example, two compositions that are substantially the same, have only incidental chemical variation. As another example, composition that is substantially a first constituent means the composition may further include <1% of any other constituent. A composition that is substantially first and second constituents means the composition may further include <1% of any constituent substituted for either the first or second constituent.

In accordance with embodiments herein, a plug of dielectric material is formed within a trench or other recess within subfin semiconductor material before or after the formation of transistor source or drain semiconductor material. Once formed, the dielectric trench plug may ensure source or drain semiconductor material is not exposed during subsequent fabrication of backside metallization, avoiding the formation of an electrical short to the source or drain semiconductor material. In some embodiments, the dielectric trench plug is formed during backside processing wherever source or drain semiconductor material is exposed during a planarization polish. For example, upon exposure, source or drain semiconductor material may be recessed from the backside and replaced with a plug of dielectric material. In other embodiments, the dielectric trench plug is formed during frontside processing. For example, a planarizing dielectric material may be deposited within trenches in a subfin semiconductor material and etched back to form plugs at the bottom of the trenches prior to source/drain semiconductor material deposition.

Depending on the implementation, a dielectric trench plug may have a chemical composition unique from other dielectric materials in a transistor structure, or not. As further described below, dielectric trench plugs integrated into transistor structures in accordance with embodiments herein may have various physical characteristics indicative of particular fabrication techniques.

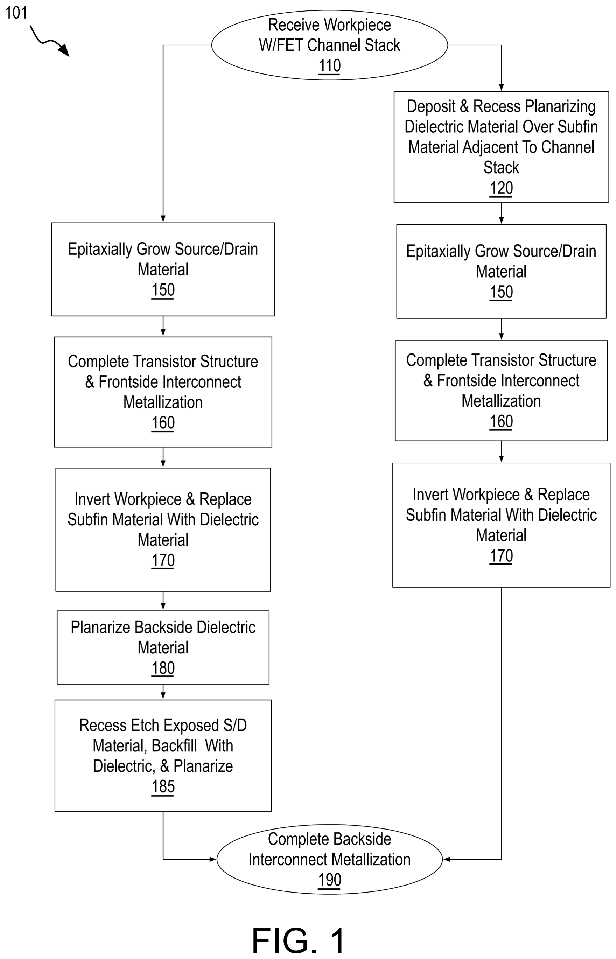

FIG. 1 is a flow diagram illustrating methods 101 for fabricating a transistor structure with source and drain semiconductor structures that are insulated from backside metallization with an intervening dielectric trench plug, in accordance with some exemplary embodiments. Methods 101 begin at input 110 with receipt of a workpiece including field effect transistor (FET) structures comprising one or more channel semiconductor material layers within a channel stack. In some examples, the workpiece received at input 110 comprises a 300-450 mm diameter wafer. The workpiece may include a substantially monocrystalline subfin material and any number of transistor channel material layers over the subfin semiconductor material. Depending on the IC manufacturing process, various other transistor features may also be present on the workpiece. For example, a gate electrode may be present, and various dielectric materials may be present, etc.

Following input 110, methods 101 continue either at block 120 where dielectric trench plugs are formed during IC frontside processing, or at block 150 where dielectric trench plugs are formed during IC backside processing. For both embodiments, dielectric trench plugs are formed at a bottom, or base, of source and drain semiconductor material bodies that could otherwise become exposed to backside interconnect metallization, and potentially short a backside interconnect metallization feature to one or more terminals of one or more transistor structures.

For embodiments where block 120 is not practiced, methods 101 instead proceed from input 110 to block 150 where source/drain semiconductor material is epitaxially grown over regions of subfin material adjacent to a transistor channel stack. In preparation for epitaxial growth, the subfin semiconductor material may be first etched, forming a trench on opposite sides of a transistor channel stack. The source/drain semiconductor material may seed from channel semiconductor material and/or may seed upon subfin semiconductor material at the base of each trench.

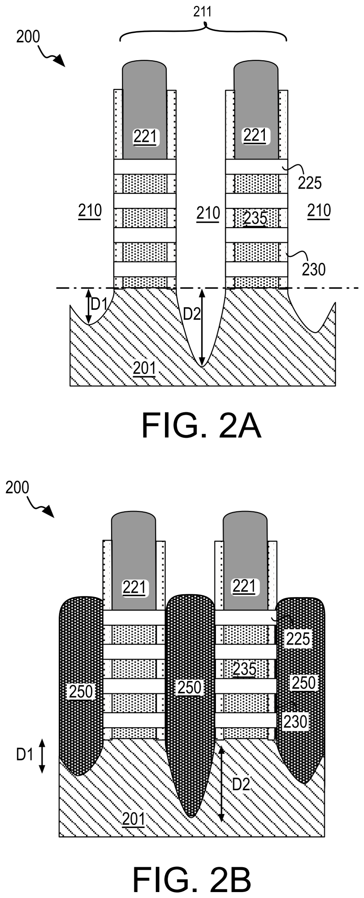

FIG. 2A- 2B are cross-sectional views of a transistor structure 200 evolving to include source and drain semiconductor material as methods 101 are practiced in accordance with some embodiments where the source and drain semiconductor material is formed prior to the formation a dielectric trench plug. In the example illustrated in FIG. 2A, transistor structure 200 comprises a transistor channel material stack 211. Transistor channel material stacks 211 may be associated with a first conductivity type. In some exemplary embodiments, transistor channel material stacks 211 are associated with an N-type (NMOS) transistor structures. In other embodiments, transistor channel material stacks 211 are associated with a P-type (PMOS) transistor structures.

Channel material stacks 211 comprise a plurality of bilayers. Each bilayer may comprise a channel material 225 and a sacrificial material 235. The number of bilayers may vary with implementation. Channel material 225 may have any composition suitable for a channel of a field effect transistor (FET). In some examples, channel material 225 is substantially pure silicon. In other embodiments, channel material 225 comprises germanium (e.g., SiₓGe_{1-X}, GeₓSn_{1-X}, or substantially pure Ge). In some embodiments, channel material 225 includes a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, and tellurium. In still other embodiments, channel material 225 comprises one or more metals and oxygen (i.e., metal oxide semiconductor), such as, but not limited to, Indium, gallium zinc oxide (IGZO).

Regardless of chemical composition, channel material 225 is advantageously crystalline. Although the crystalline semiconductor includes polycrystalline thin film material, in some embodiments channel material 225 is substantially monocrystalline. In some examples where channel material 225 is substantially pure silicon, the crystallinity of channel material 225 is cubic with a top surface having a crystallographic orientation of (100), (111), or (110). However, other crystallographic orientations are also possible. In other examples, channel material 225 may be polycrystalline or amorphous, for example in certain metal chalcogen and/or metal oxide embodiments.

Sacrificial material 235 has a different composition than channel material 225. In some examples, sacrificial material 235 has more germanium than channel material 225. For example, where channel material 225 is predominantly silicon, sacrificial material 235 is Si₁₋ₓGe_{X}, with x advantageously between 0.3-0.35. In other embodiments, sacrificial material 235 has less germanium than channel material 225. For example, where the channel material 225 is Si₁₋ₓGe_{X}, sacrificial material 235 may be predominantly silicon. In other embodiments where channel material 225 is a first metal chalcogenide, sacrificial material 235 may be a second metal chalcogenide or a metal oxide, for example.

As further illustrated in FIG. 2A, transistor channel material stacks 211 are over a subfin material 201 with a portion of subfin material 201 adjacent to the channel material stacks exposed at a bottom of trenches 210. In exemplary embodiments, subfin material 201 is a portion a (mono)crystalline substrate material. For example, subfin material 201 may be substantially monocrystalline silicon (e.g., with only trace impurities and/or crystal defects). As shown, a top surface of subfin semiconductor material 201 within a trench 210 may be recessed to a range of depths from a minimum depth D1 to a maximum depth D2 relative to a reference plane of subfin semiconductor material 201 directly below channel material stacks 211. Although depths D1-D2 may vary with implementation, in some examples depth D1 is around 10 nm and depth D2 is 30-40 nm, or more.

Channel material stacks 211 include a sidewall spacer dielectric material 230 protecting underlying channel material. Sidewall spacer dielectric material 230 may comprise a silicon-based dielectric (e.g., SiO₂, Si₃N₄, SiON, etc.). Optionally, adjacent layers of channel material 225 may be recess etched, for example with an isotropic etch process selective to the channel semiconductor material, to form a dimple (not depicted) that may then be backfilled with an additional sidewall spacer dielectric material. Transistor channel material stacks 211 further include one or more cap dielectric materials 221, which may be, for example, a silicon-based dielectric such as SiO₂, Si₃N₄, SiON, etc.

As further shown in FIG. 2B, source and drain semiconductor material 250 is epitaxially grown on crystalline seed surfaces. Source and drain semiconductor material 250 forms on portions of subfin material 201 adjacent to channel material stacks 211 and forms on ends of the channel material 225. Source and drain semiconductor material 250 substantially backfills trenches 210 so that one body of source and drain semiconductor material 250 may extend only to depth D1 while another body of source and drain semiconductor material 250 extends to depth D2.

Source and drain semiconductor material 250 may comprise any semiconductor material having a high concentration of impurities that impart a particular conductivity. In some exemplary embodiments where channel material stacks 211 are associated with PMOS FET structures, PMOS source and drain semiconductor material 250 is a Si₁₋ₓGeₓ alloy further including acceptor impurities imparting p-type electrical conductivity. In some other embodiments where channel material stacks 211are associated with NMOS FET structures, source and drain semiconductor material 250 is substantially pure silicon (i.e., only Group IV element is silicon) further including donor impurities imparting n-type electrical conductivity.

Returning to FIG. 1, methods 101 continue at block 160 where any further transistor fabrication is completed, for example with the formation of a gate stack further comprising a gate electrode and a gate insulator between the gate electrode and channel semiconductor material. Contact metallization, etc. may also be fabricated at block 160 according to any known techniques, as embodiments are not limited in this respect.

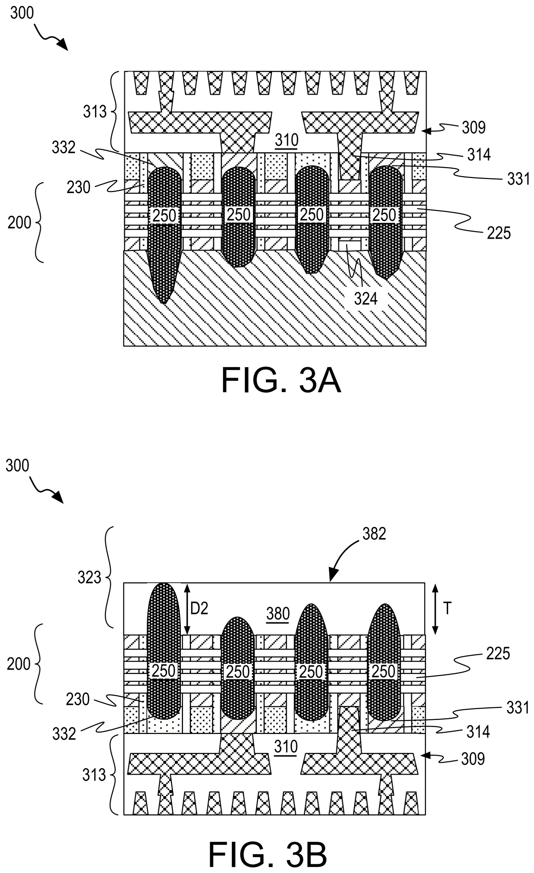

Following completion of transistor structures, a frontside transistor interconnect metallization structure may then be fabricated over a first side of the transistor structures according to any known techniques, such as any damascene and/or subtractive patterning processes. In the example shown in FIG. 3A, IC die structure 300 includes frontside transistor interconnect metallization structure 313, which further includes one or more interconnect metallization levels 309 embedded in dielectric material 310. Interconnect metallization levels 309 are interconnected to one or more terminals of transistor structures 200. In the illustrated example, a frontside metallization feature 314 is in direct contact with a gate electrode 324. Other frontside metallization features may similarly be electrically coupled to a drain contact metallization 331, or a source contact metallization 332.

Returning to FIG. 1, methods 101 continue at block 170 where the IC die workpiece is inverted and backside processing is commenced. Backside processing may vary with implementation. However, in some examples, the subfin semiconductor material is at least thinned and may be completely removed. The subfin semiconductor material may be thinned, for example, with planarization/grinding processes and then further removed with a chemical etch process selective to the composition of the substrate until the subfin material is removed. In the example illustrated in FIG. 3B, IC die structure 300 has been inverted for backside processing and subfin semiconductor material 201 has been removed. In exemplary embodiments where subfin semiconductor material 201 is silicon, removal of the subfin material may include a silicon selective chemical etch. With a subfin material removal process that is selective to source/drain semiconductor material 250, a backside of source/drain semiconductor material 250 is non-coplanar with gate electrode 324. For example, a backside of source/drain semiconductor material 250A may be 10nm, or more, from being coplanar with gate electrode 324. dielectric material 380 has been deposited over source and drain semiconductor material 250. In the absence subfin material, dielectric material 380 is in direct contact with gate electrode 324. Dielectric material 380 may have any chemical composition and may be deposited with any deposition process suitable for the composition and offering adequate thickness conformality, such as chemical vapor deposition (CVD) or atomic layer deposition (ALD). In some examples, dielectric material 380 is a silicon-based dielectric, such as such as SiO₂, Si₃N₄, SiON, SiOCH, etc.

Returning to FIG. 1, methods 101 continue at block 180 where backside processing continues with a planarization polish (i.e., CMP), which may expose source and drain semiconductor material where the thickness of dielectric material is the least. In the example illustrated in FIG. 3B, a backside surface 382 of dielectric material 380 has been planarized to some maximum layer thickness T. Source and drain semiconductor material 250 can be expected to breakthrough backside surface 382 wherever depth D2 exceeds thickness T.

Returning to FIG. 1, methods 101 continue at block 185 where semiconductor material exposed during planarization is selectively etched with a suitable etchant to form a recess or trench that is then backfilled with a dielectric material. The dielectric material deposited may be planarized with surrounding materials, defining a plug of dielectric material that remains only where source and drain semiconductor material was removed. Methods 101 then complete with the formation of a backside interconnect metallization structure at output 190.

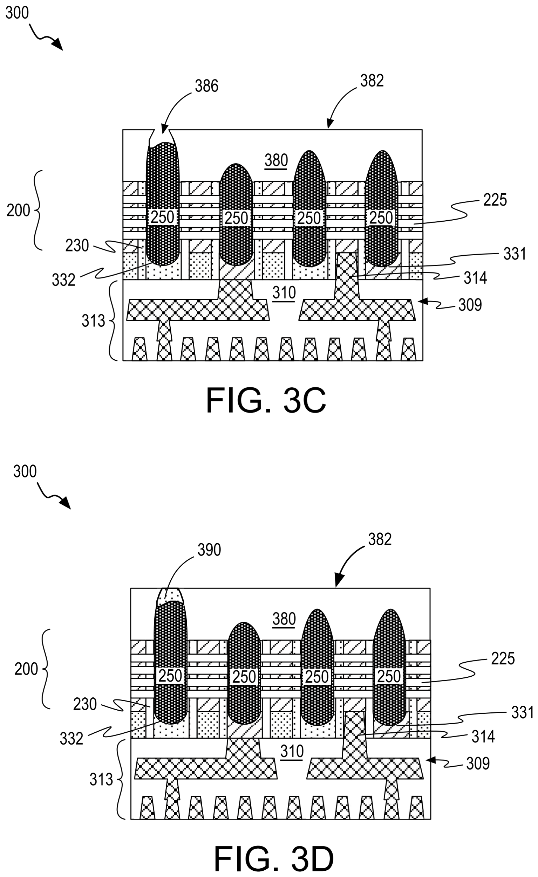

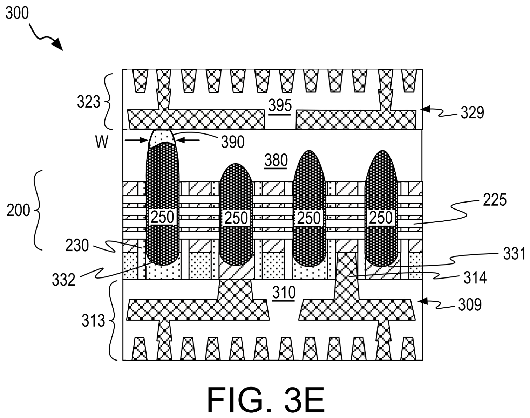

In the example further illustrated in FIG. 3C, source and drain semiconductor material 250 exposed at backside surface 382 has been etched selectively relative to dielectric material 380, for example with a silicon-selective or SiGe-selective chemical etch performed for a predetermined duration, to form a recess or trench 386 of adequate depth. In FIG. 3D, a dielectric trench plug 390 has been formed by backfilling recess 386 with a dielectric material of any suitable composition, such as, a silicon-based dielectric material (e.g., SiO₂, Si₃N₄, SiON, SiOCH, etc.). The dielectric material is then planarized with the surrounding dielectric material 380. As illustrated, dielectric trench plug 390 has a tapered sectional width W associated with a shape of the trench formed into subfin semiconductor material prior to deposition of source/drain semiconductor material 250 during frontside processing. As shown in FIG. 3E, the width W of dielectric trench plug 390 decreases with greater distance from source and drain semiconductor material 250.

In FIG. 3E, IC die structure 300 has evolved to further include backside transistor interconnect metallization 323 over dielectric material 380. Interconnect metallization structure 323 further includes one or more interconnect metallization levels 329 embedded in a dielectric material 395. Dielectric trench plug 390 electrically insulates a nearest one of interconnect metallization levels 329 from those bodies of source and drain semiconductor material 250 that would otherwise extend through dielectric material 380 and directly contact backside interconnect metallization. Notably, no dielectric trench plug 390 is formed upon bodies of source and drain semiconductor material 250 that extend only partially through dielectric material 380.

In alternative embodiments where dielectric trench plugs are instead fabricated during frontside processing, methods 101(FIG. 1) proceed from input 110 to block 120. At block 120, a planarizing dielectric material is deposited over subfin material adjacent to transistor channel stacks. The dielectric material is then recess etched by a predetermined amount to form the dielectric trench plugs. The planarizing dielectric material may be a spin-on or spray-on polymer (organic) dielectric material, for example. In other examples, the planarizing dielectric material is a carbon-based inorganic material, for example deposited with a CVD process. If the dielectric material is not sufficiently self-planarizing, a polish process may be practiced to planarized a top surface of the dielectric material. Once planarized, a blanket (unmasked) etchback process may be performed to reduce the thickness of the dielectric material retained adjacent to transistor channel stacks.

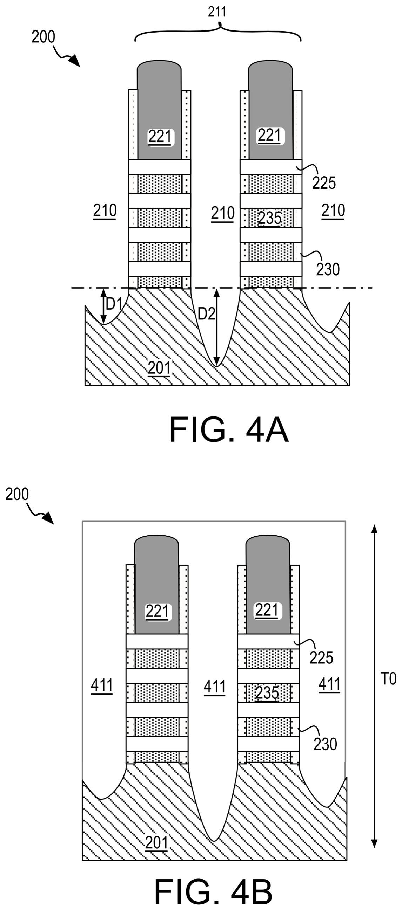

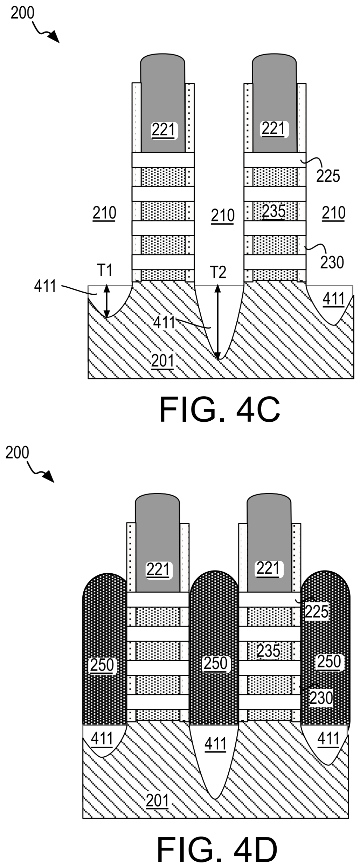

FIG. 4A-4B are cross-sectional views of transistor structure 200 evolving to include a dielectric trench plug prior to subsequent deposition of source and drain semiconductor material. In the example illustrated in FIG. 4A, transistor structure 200 again comprises transistor channel material stacks 211, which at this point in the fabrication flow comprise a plurality of bilayers. Each bilayer may comprise channel material 225 and sacrificial material 235, where each may have any of the compositions described elsewhere herein. In some examples, channel material 225 is substantially pure silicon. In other examples, channel material 225 comprises germanium (e.g., SiₓGe_{1-X}, GeₓSn_{1-X}, or substantially pure Ge). Sacrificial material 235 has a different composition than channel material 225 (e.g., more or less germanium than channel material 225).

As shown in FIG. 4A, a portion of subfin material 201 adjacent to the channel material stacks is exposed at a bottom of trenches 210. A top surface of subfin semiconductor material 201 within a trench 210 may be recessed with a semiconductor material etchant to a range of depths from minimum depth D1 to maximum depth D2 relative to the illustrated reference plane through subfin semiconductor material 201 directly below channel material stacks 211.

As shown in FIG. 4B, a planarizing dielectric material 411 has been deposited to an initial thickness T0, which covers and planarizes over all topography associated with channel stacks 211. Dielectric material 411 substantially fills trenches 210 and may be SiO₂ or SiOCH, for example. An etch process selective to dielectric material 411 (relative to cap dielectric material 221 and/or spacer dielectric 230) recesses the planar top surface of dielectric material 411 into discrete dielectric trench plugs 411, which range in thickness from T1 to T2, as function of the trench depth D1 to D2.

Returning to FIG. 1, methods 101 continue at block 150 with deposition of source and drain semiconductor material. As further shown in FIG. 4D, source and drain semiconductor material 250 is epitaxially grown on crystalline seed surfaces, for example at exposed ends of the channel material 225. Source and drain semiconductor material 250 extends over dielectric trench plugs 411. As described elsewhere herein, source and drain semiconductor material 250 may comprise any semiconductor material having a high concentration of impurities that impart a particular conductivity, such as a Si₁₋ₓGeₓ alloy further including acceptor impurities imparting p-type electrical conductivity, or substantially pure silicon further including donor impurities imparting n-type electrical conductivity.

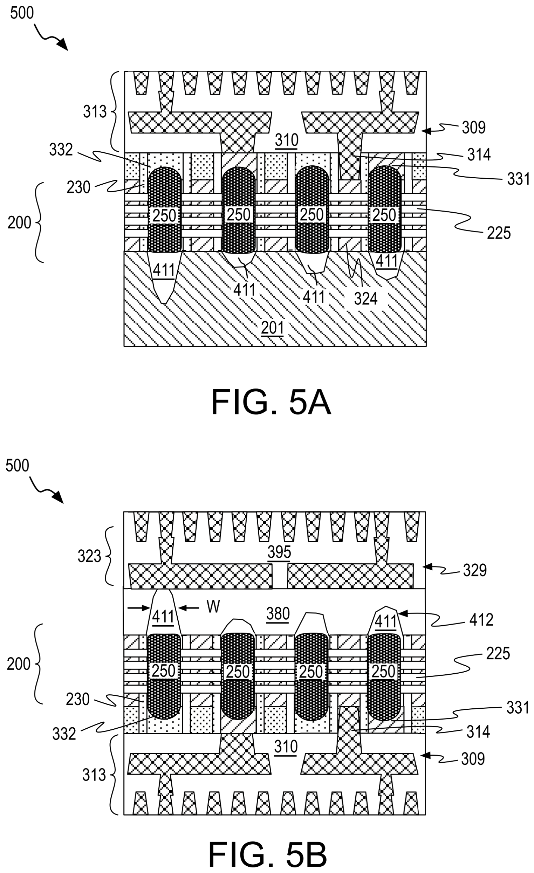

Returning to FIG. 1, methods 101 continue at block 160 where transistor structure fabrication is completed, for example with the fabrication of a gate stack further comprising a gate electrode and a gate insulator between the gate electrode and channel semiconductor material. Transistor terminals comprising the gate electrode and source and drain semiconductor may then be interconnected with other transistors through layers of metallization features fabricated during frontside processing. In the example shown in FIG. 5A, IC die structure 500 includes frontside transistor interconnect metallization structure 313, which further includes one or more interconnect metallization levels 309 embedded in dielectric material 310. Interconnect metallization levels 309 are interconnected to one or more terminals of transistor structures 200. In the illustrated example, a frontside metallization feature 314 is again in direct contact with gate electrode 324. Other frontside metallization features may similarly be electrically coupled to a drain contact metallization 331, or a source contact metallization 332.

Returning to FIG. 1, methods 101 continue at block 170 where the IC die workpiece is inverted for backside processing. Although backside processing may vary with implementation, in some examples the subfin semiconductor material is at least thinned and may be completely removed. In the example illustrated in FIG. 5B, IC die structure 500 has been inverted and subfin semiconductor material 201 has been removed. In exemplary embodiments where subfin semiconductor material 201 is silicon, removal of the subfin material may include a silicon selective chemical etch that preserves dielectric trench plugs 411. A dielectric material 380 deposited upon the backside of transistor structure 200 is therefore adjacent to a sidewall of dielectric trench plugs 411 and may substantially surround individual ones of dielectric trench plugs 411.

In some embodiments, dielectric material 380 has a different composition than dielectric trench plugs 411. However, even for embodiments where dielectric material 380 has the same composition as dielectric trench plugs 411, a physical interface 412 will be visible, for example in a transmission electron microscopy (TEM) image. Within the illustrated cross-section, dielectric trench plugs 411 have a tapered sectional width W that decreases with increasing distance from source and drain semiconductor material 250. Notably, a dielectric trench plug 411 is contact with each and every body of source or drain semiconductor material 250. Hence, where dielectric trench plug 411 has a minimal thickness T1, dielectric material 380 will also be between a nearest interconnect metallization 329 and source/drain semiconductor material 250. Only where dielectric trench plug 411 has a maximum thickness T2 that also exceeds the thickness of dielectric material 380 will a nearest interconnect metallization 329 be in direct contact with dielectric trench plug 411.

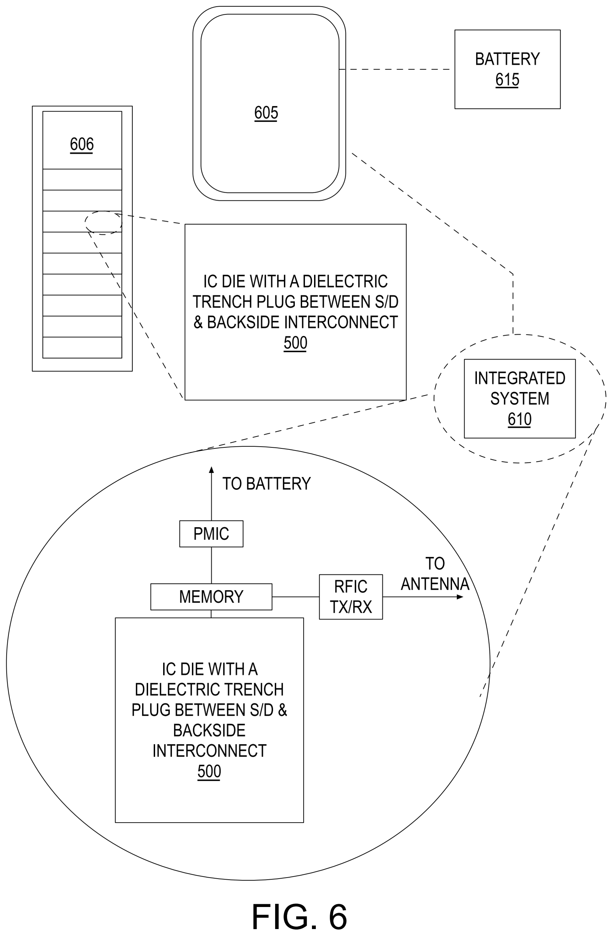

The transistor structures and IC die structures described above may be employed in a wide range of IC devices and further integrated in a wide range of computer-based applications. FIG. 6 illustrates a mobile computing platform 605 and a server machine 606, each employing IC die structure 500 (or 300) including transistor structures that have a dielectric trench plug between backside metallization and source and drain semiconductor, for example as described elsewhere herein.

Server machine 606 may be any commercial server, for example including any number of high-performance computing platforms disposed within a rack and networked together for electronic data processing, which in the exemplary embodiment includes IC die structure 500 (or 300) including transistor structures that have a dielectric trench plug between backside metallization and source and drain semiconductor, for example as described elsewhere herein. The mobile computing platform 605 may be any portable device configured for each of electronic data display, electronic data processing, wireless electronic data transmission, or the like. For example, the mobile computing platform 605 may be any of a tablet, a smart phone, laptop computer, etc., and may include a display screen (e.g., a capacitive, inductive, resistive, or optical touchscreen), an integrated system 610, and a battery 615.

As illustrated in the expanded view of FIG. 6, one or more of a power management integrated circuit (PMIC) or RF (wireless) integrated circuit (RFIC) including a wideband RF (wireless) transmitter and/or receiver may be further coupled to IC die structure 500. A PMIC may perform battery power regulation, DC-to-DC conversion, etc., and so has an input coupled to battery 615 and an output providing a current supply to other functional modules. An RFIC may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G and beyond.

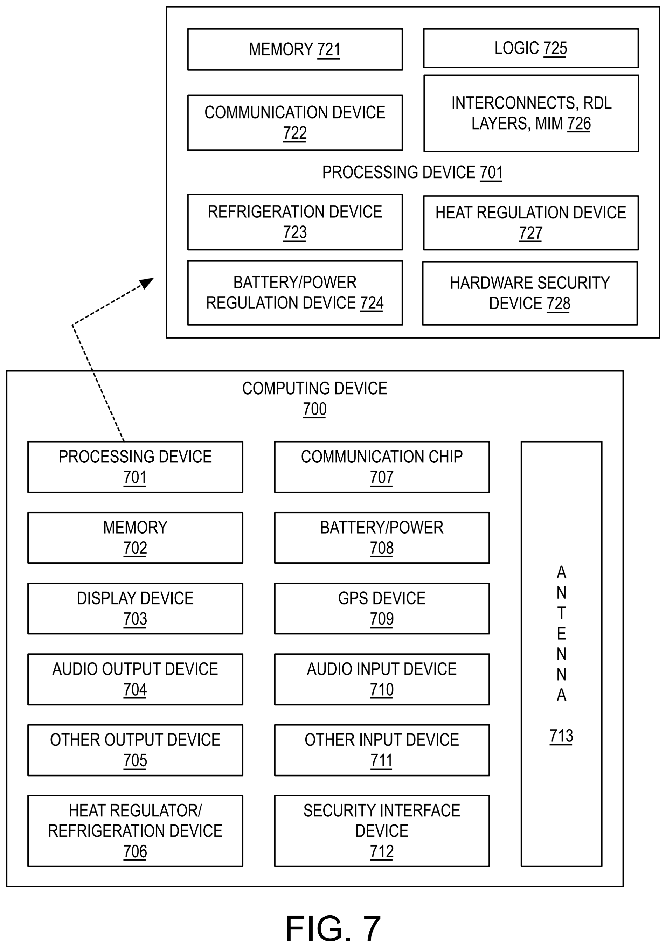

FIG. 7 is a block diagram of a cryogenically cooled computing device 700 in accordance with some embodiments. For example, one or more components of computing device 700 may include transistors with silicon source/drain semiconductor material that has been protected with an etch stop during silicon subfin removal and contacted with backside metallization, for example as described elsewhere herein. A number of components are illustrated in FIG. 13 as included in computing device 700, but any one or more of these components may be omitted or duplicated, as suitable for the application. In some embodiments, some or all of the components included in computing device 700 may be attached to one or more printed circuit boards (e.g., a motherboard). In some embodiments, various ones of these components may be fabricated onto a single system-on-a-chip (SoC) die. Additionally, in various embodiments, computing device 700 may not include one or more of the components illustrated in FIG. 7, but computing device 700 may include interface circuitry for coupling to the one or more components. For example, computing device 700 may not include a display device 703, but may include display device interface circuitry (e.g., a connector and driver circuitry) to which display device 703 may be coupled.

Computing device 700 may include a processing device 701 (e.g., one or more processing devices). As used herein, the term processing device or processor indicates a device that processes electronic data from registers and/or memory to transform that electronic data into other electronic data that may be stored in registers and/or memory. Processing device 701 may include a memory 721, a communication device 722, a refrigeration/active cooling device 723, a battery/power regulation device 724, logic 725, interconnects 726 (i.e., optionally including redistribution layers (RDL) or metal-insulator-metal (MIM) devices), a heat regulation device 727, and a hardware security device 728.

Processing device 701 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 701 may include a memory 721, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, a memory 702 shares a die with processing device 701. This memory may be used as cache memory and may include embedded dynamic random-access memory (eDRAM) or spin transfer torque magnetic random-access memory (STT-M RAM).

Computing device 700 may include a heat regulation/refrigeration device 706. Heat regulation/refrigeration device 706 may maintain processing device 701 (and/or other components of computing device 700) at a predetermined low temperature during operation. This predetermined low temperature may be any temperature discussed elsewhere herein.

In some embodiments, computing device 700 may include a communication chip 707 (e.g., one or more communication chips). For example, the communication chip 707 may be configured for managing wireless communications for the transfer of data to and from computing device 700. The term "wireless" and its derivatives may be used to describe circuits, devices, systems, methods, techniques, communications channels, etc., that may communicate data through the use of modulated electromagnetic radiation through a nonsolid medium.

Communication chip 707 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). Communication chip 707 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 707 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 707 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 707 may operate in accordance with other wireless protocols in other embodiments. Computing device 700 may include an antenna 713 to facilitate wireless communications and/or to receive other wireless communications (such as AM or FM radio transmissions).

In some embodiments, communication chip 707 may manage wired communications, such as electrical, optical, or any other suitable communication protocols (e.g., the Ethernet). As noted above, communication chip 707 may include multiple communication chips. For instance, a first communication chip 707 may be dedicated to shorter-range wireless communications such as Wi-Fi or Bluetooth, and a second communication chip 707 may be dedicated to longer-range wireless communications such as GPS, EDGE, GPRS, CDMA, WiMAX, LTE, EV-DO, or others. In some embodiments, a first communication chip 707 may be dedicated to wireless communications, and a second communication chip 707 may be dedicated to wired communications.

Computing device 700 may include battery/power circuitry 708. Battery/power circuitry 708 may include one or more energy storage devices (e.g., batteries or capacitors) and/or circuitry for coupling components of computing device 700 to an energy source separate from computing device 700 (e.g., AC line power).

Computing device 700 may include a display device 703 (or corresponding interface circuitry, as discussed above). Display device 703 may include any visual indicators, such as a heads-up display, a computer monitor, a projector, a touchscreen display, a liquid crystal display (LCD), a light-emitting diode display, or a flat panel display, for example.

Computing device 700 may include an audio output device 704 (or corresponding interface circuitry, as discussed above). Audio output device 704 may include any device that generates an audible indicator, such as speakers, headsets, or earbuds, for example.

Computing device 700 may include an audio input device 710 (or corresponding interface circuitry, as discussed above). Audio input device 710 may include any device that generates a signal representative of a sound, such as microphones, microphone arrays, or digital instruments (e.g., instruments having a musical instrument digital interface (MIDI) output).

Computing device 700 may include a global positioning system (GPS) device 709 (or corresponding interface circuitry, as discussed above). GPS device 709 may be in communication with a satellite-based system and may receive a location of computing device 700, as known in the art.

Computing device 700 may include another output device 705 (or corresponding interface circuitry, as discussed above). Examples include an audio codec, a video codec, a printer, a wired or wireless transmitter for providing information to other devices, or an additional storage device.

Computing device 700 may include another input device 711 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 700 may include a security interface device 712. Security interface device 712 may include any device that provides security measures for computing device 700 such as intrusion detection, biometric validation, security encode or decode, managing access lists, malware detection, or spyware detection. In some examples, security interface device 712 comprises OTP ROM further including a via MIM fuse, for example as described elsewhere herein.

Computing device 700, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments described above, but can instead be practiced with modification and alteration without departing from the scope of the appended claims. For example, the above embodiments may include specific combinations of features as further provided below.

In first examples, an apparatus comprises a transistor structure comprising a gate electrode, a source semiconductor material, and a drain semiconductor material. The apparatus comprises a dielectric trench plug at a bottom of at least one of the source semiconductor material and the drain semiconductor material. The apparatus comprises a first interconnect metallization structure over a frontside of the transistor structure. The apparatus comprises a second interconnect metallization structure over a backside of the transistor structure. The dielectric trench plug is between the second interconnect metallization structure and the source semiconductor material or the drain semiconductor material.

In second examples, for any of the first examples the apparatus further comprises a second dielectric material layer in contact with the dielectric trench plug.

In third examples, for any of the second examples the second dielectric material layer has a different composition than the dielectric trench plug.

In fourth examples, for any of the first through third examples, a first dielectric trench plug is at a bottom of a first of the source semiconductor material and the drain semiconductor material, a second dielectric trench plug is at a bottom of a second of the source semiconductor material and the drain semiconductor material, and the first dielectric trench plug is in contact with the second interconnect metallization.

In fifth examples, for any of the fourth examples the second dielectric trench plug is between the second interconnect metallization and the second dielectric trench plug.

In sixth examples, for any of the first examples a first of the source semiconductor material and the drain semiconductor material extends to a depth deeper than a second of the source semiconductor material and the drain semiconductor material. The dielectric trench plug is between the second interconnect metallization and the first of the source semiconductor material and the drain semiconductor material. There is no dielectric trench plug between the second interconnect metallization and the second of the source semiconductor material and the drain semiconductor material.

In seventh examples, for any of the first through sixth examples the dielectric trench plug is in contact with the second interconnect metallization.

In eighth examples, for any of the first through seventh examples the dielectric trench plug has a sectional width that decreases with greater distance from the source or drain semiconductor material.

In ninth examples, an integrated circuit (IC) structure comprises a transistor structure, comprising a gate around a plurality of transistor channel layers in a stack, and a source semiconductor material and a drain semiconductor material coupled to the channel layers in the stack. At least one of the source or drain semiconductor material is over, and in contact with, a first dielectric material. The IC structure comprises a first interconnect metallization structure over a first side of the transistor structure, a second dielectric material layer over a second side of the transistor structure and adjacent to the first dielectric material, and a second interconnect metallization structure over the second dielectric material layer and in direct contact with the first dielectric material.

In tenth examples, for any of the ninth examples the second dielectric material layer is in contact with a sidewall of the first dielectric material, and the second interconnect metallization structure extends over both first dielectric material and the second dielectric material layer.

In eleventh examples, for any of the tenth examples the first dielectric material comprises a first dielectric trench plug at a bottom of a first of the source semiconductor material and the drain semiconductor material. A second dielectric trench plug comprising the first dielectric material is at a bottom of a second of the source semiconductor material and the drain semiconductor material. The first dielectric trench plug is in contact with the second interconnect metallization. The second dielectric material is between the second interconnect metallization and the second dielectric trench plug.

In twelfth examples, for any of the ninth through eleventh examples a first of the source semiconductor material and the drain semiconductor material extends to a depth deeper than a second of the source semiconductor material and the drain semiconductor material. The first dielectric material is between the second interconnect metallization and the first of the source semiconductor material and the drain semiconductor material. The first dielectric material is absent from between the second interconnect metallization and the second of the source semiconductor material and the drain semiconductor material.

In thirteenth examples, for any of the ninth through twelfth examples the first dielectric material comprises a trench plug with a sectional width that decreases with greater distance from the source or drain semiconductor material.

In fourteenth examples, a method of fabricating an integrated circuit (IC) structure comprise receiving a transistor structure comprising a channel material layer stack over a subfin semiconductor material. The method comprises forming a source semiconductor material and a drain semiconductor material adjacent to the channel material layer stack. The method comprises forming a first interconnect metallization structure over a frontside of the transistor structure. The method comprises forming a second interconnect metallization structure over a backside of the transistor structure. The method comprises forming a dielectric trench plug between the second interconnect metallization structure and a bottom of at least one of the source semiconductor material and the drain semiconductor material.

In fifteenth examples, for any of the fourteenth examples forming the dielectric trench plug comprises etching a first trench into the subfin semiconductor material on a first side of the channel material layer stack, etching a second trench into the subfin semiconductor material on a second side of the channel material stack, and at least partially backfilling the first and second trenches with a dielectric material. Forming the source semiconductor material and the drain semiconductor material comprises depositing the source semiconductor material over the dielectric material within the first trench and depositing the drain semiconductor material over the dielectric material within the second trench.

In sixteenth examples, for any of the fourteenth through fifteenth examples forming the dielectric trench plug comprises performing a first planarization polish on a backside of the transistor structure, forming a recess in the source semiconductor material or the drain semiconductor material exposed by the planarization polish, backfilling the recess with a dielectric material, and performing a second planarization polish on the backside of the transistor structure prior to forming the second interconnect metallization structure.

In seventeenth examples, for any of the sixteenth examples the method comprises etching a first trench into the subfin semiconductor material on a first side of the channel material stack, etching a second trench into the subfin semiconductor material on a second side of the channel material stack, at least partially backfilling the first trench with the source semiconductor material, and at least partially backfilling the second trench with the drain semiconductor material.

In eighteenth examples, for any of the fourteenth through seventeenth examples the method further comprises replacing the subfin semiconductor material with a layer of dielectric material.

In nineteenth examples, for any of the eighteenth examples replacing the subfin semiconductor material comprises etching the subfin semiconductor material from around the dielectric trench plug.

In twentieth examples, for any of the fourteenth through nineteenth examples the subfin semiconductor material is silicon, and the dielectric trench plug comprises a compound of silicon and oxygen.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An apparatus, comprising:
a transistor structure comprising a gate electrode, a source semiconductor material, and a drain semiconductor material;
a dielectric trench plug at a bottom of at least one of the source semiconductor material and the drain semiconductor material;
a first interconnect metallization structure over a frontside of the transistor structure; and
a second interconnect metallization structure over a backside of the transistor structure, wherein the dielectric trench plug is between the second interconnect metallization structure and the source semiconductor material or the drain semiconductor material.

2. The apparatus of claim 1, wherein the apparatus further comprises a second dielectric material layer in contact with the dielectric trench plug.

3. The apparatus of claim 2, wherein the second dielectric material layer has a different composition than the dielectric trench plug.

4. The apparatus of any one of claims 1-3, wherein:
a first dielectric trench plug is at a bottom of a first of the source semiconductor material and the drain semiconductor material;
a second dielectric trench plug is at a bottom of a second of the source semiconductor material and the drain semiconductor material; and
the first dielectric trench plug is in contact with the second interconnect metallization structure.

5. The apparatus of claim 4, wherein the second dielectric trench plug is between the second interconnect metallization and the second dielectric trench plug.

6. The apparatus of any one of claims 1-5, wherein:
a first of the source semiconductor material and the drain semiconductor material extends to a depth deeper than a second of the source semiconductor material and the drain semiconductor material;
the dielectric trench plug is between the second interconnect metallization and the first of the source semiconductor material and the drain semiconductor material; and
there is no dielectric trench plug between the second interconnect metallization and the second of the source semiconductor material and the drain semiconductor material.

7. The apparatus of any one of claims 1-6, wherein the dielectric trench plug is in contact with the second interconnect metallization.

8. The apparatus of any one of claims 1-7, wherein the dielectric trench plug has a sectional width that decreases with greater distance from the source or drain semiconductor material.

9. A method of fabricating an integrated circuit (IC) structure, the method comprising:
receiving a transistor structure comprising a channel material layer stack over a subfin semiconductor material;
forming a source semiconductor material and a drain semiconductor material adjacent to the channel material layer stack;
forming a first interconnect metallization structure over a frontside of the transistor structure;
forming a second interconnect metallization structure over a backside of the transistor structure; and
forming a dielectric trench plug between the second interconnect metallization structure and a bottom of at least one of the source semiconductor material and the drain semiconductor material.

10. The method of claim 9, wherein:
forming the dielectric trench plug comprises etching a first trench into the subfin semiconductor material on a first side of the channel material layer stack, etching a second trench into the subfin semiconductor material on a second side of the channel material layer stack, and at least partially backfilling the first and second trenches with a dielectric material; and
forming the source semiconductor material and the drain semiconductor material comprises depositing the source semiconductor material over the dielectric material within the first trench and depositing the drain semiconductor material over the dielectric material within the second trench.

11. The method of any one of claims 9-10, wherein forming the dielectric trench plug comprises:
performing a first planarization polish on a backside of the transistor structure;
forming a recess in the source semiconductor material or the drain semiconductor material exposed by the planarization polish;
backfilling the recess with a dielectric material; and
performing a second planarization polish on the backside of the transistor structure prior to forming the second interconnect metallization structure.

12. The method of claim 11, further comprising:
etching a first trench into the subfin semiconductor material on a first side of the channel material layer stack;
etching a second trench into the subfin semiconductor material on a second side of the channel material layer stack;
at least partially backfilling the first trench with the source semiconductor material; and
at least partially backfilling the second trench with the drain semiconductor material.

13. The method of any one of claims 9-12, further comprising replacing the subfin semiconductor material with a layer of dielectric material.

14. The method of claim 13, wherein replacing the subfin semiconductor material comprises etching the subfin semiconductor material from around the dielectric trench plug.

15. The method of any one of claims 9-14, wherein:
the subfin semiconductor material is silicon; and
the dielectric trench plug comprises a compound of silicon and oxygen.
